# EUROPEAN PATENT SPECIFICATION

(11) **EP 2 178 118 B1**
(45) Date of publication and mention of the grant of the patent: **26.08.2015**
(21) Application number: 08166007.8
(22) Date of filing: 07.10.2008
(51) Int. Cl.: H01L 23/38, F21K 99/00, H01L 33/64

(54) **Light emitting diode with energy recovery system**
Lichtemittierende Diode mit Energierückgewinnungssystem
Diode électroluminescente avec système de récupération d'énergie

(43) Date of publication of application: 21.04.2010
(73) Proprietor: Zodiac Aerotechnics, 78370 Plaisir (FR)
(72) Inventor: Rittner, Wolfgang, 23623, Siblin (DE); Meckes, Rüdiger, 23919, Berkenthin (DE); Boomgaarden, Günter, 23684, Scharbeutz (DE)
(74) Representative: Eisenführ Speiser

(56) References cited:
- WO-A2-2010/010520
- DE-A1- 2 333 119
- JP-A- 2001 308 395
- JP-A- 2004 342 557
- JP-A- 2006 059 930
- JP-A- 2007 019 058
- JP-A- 2007 036 166
- JP-A- 2007 234 913
- KR-A- 20060 112 574
- US-A1- 2004 155 251
- US-A1- 2005 088 588
- US-A1- 2007 102 033

## Description

The invention relates to a light emitting diode (LED) which is electrically connected to an anode and a source.

Such LEDs are used in a plurality of applications wherein light is to be emitted at low energy consumption. A typical application for such LEDs is the use for signalling a specific status like a stand-by mode, an activating mode or a failure of an electrical device. In such applications, the LED is usually supplied with a small amount of energy to induce a small amount of light radiation from the LED sufficient to effect the signalling. In other applications LEDs are used to illuminate a field or region for a use like e.g. in a hand torch or a lamp installed in a vehicle like a car or an aircraft. In such appliances a high amount of energy is provided to the LED to induce a high amount of light radiation from said LED.

In general, the LED produces as a side effect a certain amount of heat when being provided with electrical energy. This heat must be removed from the LED which is usually achieved by heat radiation from the LED body or a coupling of the LED to a heat-dissipating element in order to avoid damage to the LED due to overheating.

JP 2007-36166 discloses a long persistence light wherein the light emitting part is electrically coupled to a battery charger and said battery charger can alternatively be electrically coupled to a Peltier device. Said Peltier device is arranged with a heat sink 6 and a heat colletting plate 5 for collecting e.g. heat by sunlight.

US 2004/0155251 A1 discloses an electronic device which is thermally coupled to a Peltier element. The Peltier element is driven by electrical energy to provide cooling to the electronic device.

It is an object of the invention to provide an LED which is capable to have a higher energy efficiency than LEDs according to the prior art. It is a further object of the invention to provide an LED which is capable to be driven with a small amount of energy in a first mode with high efficiency and which is capable to be driven in a second mode where the light emission from the LED is maximized.

These and other objects of the invention are achieved by providing an LED according to the introductory portion wherein one of the anode and the source is thermally coupled to a first heat conductor, the heat conductor being thermally coupled to a first Peltier element to convert thermal energy transmitted from and generated in the light emitting crystal when the light emitting crystal is provided with electrical energy into electrical energy.

According to the invention the heat generated in an LED is not dissipated into ambient air but converted into electrical energy using a peltier element. For this purpose, a first peltier element is thermally coupled to the anode or the source of the LED. By this arrangement, an LED arrangement is provided which is capable to recover at least a part of the energy which is converted into heat in the LED by converting said heat back into electrical energy and to thus provide a high efficiency of the whole arrangement. Thus, a partially self-sustaining LED arrangement is provided.

According to the invention, the other one of the anode and the source is thermally coupled to a second heat conductor, the second heat conductor being thermally coupled to a second Peltier element to convert thermal energy transmitted from and generated in the light emitting crystal when the light emitting crystal is provided with electrical energy into electrical energy. By this, both anode and source are each thermally coupled to a separate peltier element which results in a high recovery rate of the thermal energy generated by the LED in operation and conversion of said thermal energy into electrical energy.

It is preferred that one or both of the first and second Peltier element are electrically coupled to an electrical storage device to store electrical energy generated in the Peltier element(s). By this, the electrical energy generated in the Peltier element(s) can be stored for later use like e.g. for providing electrical energy to the LED in an emergency situation where the regular energy supplied to the LED has failed.

Further, it is preferred that one or both of the first and second Peltier element are electrically coupled to a source of electrical energy to provide energy to the Peltier element(s) in such a way that the Peltier element(s) is are cooled. According to the invention, the LED arrangement may be driven in a different mode of use wherein no electrical energy is converted in the Peltier elements from heat but rather electrical energy is provided to the Peltier elements to cool the Peltier elements to a low temperature. This embodiment employs the specific characteristics of Peltier elements which are capable to be driven in two directions, namely to generate electrical energy from a heat gradient across the element or to create a heat difference when being provided with electrical energy. In the LED arrangement according to the invention, this is particularly useful in a situation where the LED is to be driven at a high light emission rate and thus a high amount of heat is generated by the LED which might potentially damage the LED after short time of use at such high light emission rate. The risk of being damaged can be significantly decreased and the lifetime of the LED thus increased by cooling down the one or both Peltier element(s) to a low temperature. Since the Peltier elements are thermally coupled to the LED, the LED will be cooled down to a significantly lower temperature by this and will thus be driven at a significantly lower temperature than in any other arrangement according to the prior art where the heat is dissipated into ambient air by passive heat dissipation.

According to the invention, the LED arrangement comprises a control unit which is adapted to drive the light emitting diode in
- a first mode, wherein electrical energy of a first magnitude is provided to the light emitting diode and electrical energy converted from heat dissipated by the light emitting diode in the Peltier element(s) is received and provided to an electrical consumer or storage device, and in
- a second mode wherein electrical energy of a second magnitude is provided to the light emitting diode and electrical energy is provided to the the Peltier element(s) to cool the Peltier elements and to thus actively cool the light emitting diode via the Peltier elements,
- wherein the second magnitude of electrical energy is higher than the first magnitude.

According to this embodiment, the LED arrangement according to the invention is capable to be switched between two distinct drive modes wherein the first drive mode provides an efficient light emission at a low rate with recovery of the heat dissipated by the LED and conversion of said heat into electrical energy and the second mode allows a very high rate of light emission by the LED and an active cooling of said LED via the Peltier element by driving said Peltier element with electrical energy.

Such LED arrangement may be particularly useful in a situation where a permanent light emission is required for safety conditions in a standard operational mode but in specific situations of short time periods a high rate of light emission is required for e.g. illuminating a certain region or field.

A second aspect of the invention is a method of driving a light emitting diode, comprising the step of providing electrical energy to an anode and a source electrically coupled to a light emitting crystal incorporated in the light emitting diode, wherein the steps of transferring heat from the light emitting crystal to a Peltier element and converting said heat in said Peltier element into electrical energy, wherein said electrical energy generated in the Peltier element is preferably transferred to an electrical energy storage or an electrical consumer. Said method allows an efficient driving of an LED and a recovery of the energy dissipated as heat energy from said LED.

The method may be further improved in that the heat is transferred from the light emitting crystal to the Peltier element via electrical wires constituting the anode and/or the source.

Still further it is preferred that the heat is transferred from the light emitting crystal via an electrical wire constituting the anode coupling to a first Peltier element and via an electrical wire constituting the source coupling to a second Peltier element.

Finally it is preferred that electrical energy is provided to at least one Peltier element and the Peltier element is cooled down by this electrical energy if the light radiation emitted by the light emitting crystal is increased.

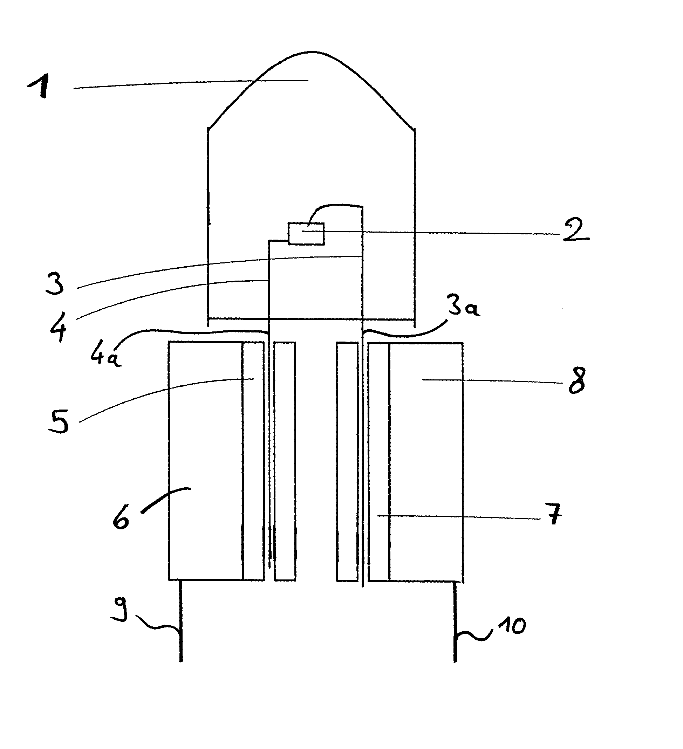

A preferred embodiment of the invention is described with reference to the figure.

The figure shows an LED body 1 incorporating a light emitting crystal 2 which is coupled to an anode 3 and a source 4.

The anode 3 and the source 4 are constituted by electrical wires 3a, 4a which exit the LED body 1 at a bottom surface.

The electrical wires are each connected to a first thermal coupling 5 and a second thermal coupling 7.

The first thermal coupling 5 is thermally coupled to a first Peltier element 6 and the second thermal coupling 7 is thermally coupled to a second Peltier element 8.

Since the Peltier elements are exposed to ambient air, the heat transferred via the electrical wires from the light emitting crystal to the Peltier element generate a heat gradient across the Peltier element.

This heat difference generates electrical energy within the Peltier elements. This electrical energy may be provided to an electrical consumer or an electrical storage device. For this purpose, the Peltier elements are electrically connected to a respective wiring 9, 10.

Vice versa, via said wiring 9, 10 connected to the Peltier element the Peltier elements may be provided with electrical energy. This will cool down the Peltier elements and will thus generate a significant temperature difference between the Peltier elements and the light emitting crystal of the LED. Thus, a significant amount of heat may be transferred from the light-emitting crystal 2 to the Peltier elements via heat conducting elements 5, 6. This will allow to drive the light emitting crystal at a very high light emission rate without the danger of damaging said light emitting crystal or any other parts of the LED for thermal reasons.

## Claims

1. Light emitting diode arrangement, comprising a light emitting diode with a light emitting crystal, electrically connected to an anode and a source,
**characterized in that** one of the anode and the source is thermally coupled to a first heat conductor, the heat conductor being thermally coupled to a first Peltier element to convert thermal energy transmitted from and generated in the light emitting crystal when the light emitting crystal is provided with electrical energy into electrical energy, wherein the other one of the anode and the source is thermally coupled to a second heat conductor, the second heat conductor being thermally coupled to a second Peltier element to convert thermal energy transmitted from and generated in the light emitting crystal when the light emitting crystal is provided with electrical energy into electrical energy.
further comprising a control unit adapted to drive the light emitting diode in
- a first mode, wherein electrical energy of a first level is provided to the light emitting diode and electrical energy converted from heat dissipated by the light emitting diode in the Peltier elements is received and provided to an electrical consumer or storage device, and in
- a second mode wherein electrical energy of a second level is provided to the light emitting diode and electrical energy is provided to the Peltier elements to cool the Peltier elements and to thus actively cool the light emitting diode via the Peltier elements,
- wherein the second level of electrical energy is higher than the first level.

2. Light emitting diode arrangement according to claim 1, wherein one or both of the first and second Peltier element are electrically coupled to an electrical storage device to store electrical energy generated in the Peltier element(s).

3. A method of driving a light emitting diode, comprising the step of providing electrical energy to an anode and a source electrically coupled to a light emitting crystal incorporated in the light emitting diode,
**characterized by** the steps of transferring heat from the light emitting crystal to a Peltier element and converting said heat in said Peltier element into electrical energy, wherein said electrical energy generated in the Peltier element is preferably transferred to an electrical energy storage or an electrical consumer wherein the heat is transferred from the light emitting crystal via an electrical wire constituting the anode coupling to a first Peltier element and via an electrical wire constituting the source coupling to a second Peltier element and
wherein
in a first mode electrical energy of a first level is provided to the light emitting crystal and electrical energy converted from heat dissipated by the light emitting crystal in the Peltier element(s) is provided to an electrical consumer or storage device and in a second mode electrical energy is provided to at least one Peltier element and the Peltier element is cooled down by this electrical energy if the light radiation emitted by the light emitting crystal is increased

4. A method according to claim 3, wherein the heat Is transferred from the light emitting crystal to the Peltier element via electrical wires constituting the anode and/or the source.

## Patentansprüche

1. Leuchtdiodenanordnung, umfassend eine Leuchtdiode mit einem lichtemittierenden Kristall, der elektrisch mit einer Anode und einer Quelle verbunden ist,
**dadurch gekennzeichnet, dass** eine der Anode und der Quelle thermisch mit einem ersten Wärmeleiter gekoppelt sind, wobei der Wärmeleiter thermisch mit einem ersten Peltier-Element gekoppelt ist, um thermische Energie aus und erzeugt in dem lichtemittierenden Kristall zu übertragen, um bei Versorgung des lichtemittierenden Kristalls diese in elektrische Energie umzuwandeln, wenn der lichtemittierenden Kristall mit elektrischer Energie versorgt wird,
wobei die andere der Anode und der Quelle thermisch mit einem zweiten Wärmeleiter gekoppelt sind, wobei der zweite Wärmeleiter thermisch mit einem zweiten Peltier-Element gekoppelt ist, um thermische Energie aus und erzeugt in dem lichtemittierenden Kristall zu übertragen, um bei Versorgung des lichtemittierenden Kristalls diese in elektrische Energie umzuwandeln, wenn der lichtemittierende Kristall mit elektrischer Energie versorgt wird, weiterhin umfassend eine Steuereinheit, ausgebildet um die Leuchtdiode in
- einer ersten Betriebsart zu betreiben, wobei die lichtemittierende Diode mit elektrischer Energie mit einem ersten Pegel versorgt wird und elektrische Energie, die durch die Peltier-Elemente aus der Abwärme der Leuchtdioden gewonnen wird, einem elektrischen Verbraucher bereitgestellt wird oder in einer Speichervorrichtung gespeichert wird, und in
- einer zweiten Betriebsart zu betreiben, wobei die lichtemittierende Diode mit elektrischer Energie mit einem zweiten Pegel versorgt wird und die Peltier-Elemente mit elektrischer Energie versorgt werden, um die Peltier-Elemente zu kühlen und somit aktiv die lichtemittierende Diode mittels der Peltier-Elemente zu kühlen,
- wobei der zweite Pegel der elektrischen Energie höher ist als der erste Pegel.

2. Leuchtdiodenanordnung nach Anspruch 1, wobei eines oder beide der ersten und der zweiten Peltier-Elemente elektrisch mit einer elektrischen Speichervorrichtung verbunden ist (sind), um die in dem(n) Peltier-Element(en) erzeugte elektrische Energie zu speichern.

3. Ein Verfahren zum Ansteuern einer lichtemittierenden Diode, umfassend den Schritt der Bereitstellung elektrischer Energie an eine Anode und eine Quelle, die elektrisch mit einem lichtemittierenden Kristall der in der Leuchtdiode integriert ist, gekoppelt ist,
**gekennzeichnet durch** die Schritte des Übertragens von Wärme aus dem lichtemittierenden Kristall an ein Peltier-Element und Umwandeln der übertragenen Wärme in dem Peltier-Element in elektrische Energie, wobei die elektrische Energie, die in dem Peltier-Element erzeugt wird, vorzugsweise an einen elektrischen Energiespeicher oder einen elektrischen Verbraucher übertragen wird,
wobei die Wärme aus dem lichtemittierenden Kristall über eine elektrische Leitung, welche die Anode mit einem ersten Peltier-Element koppelt und über eine elektrische Leitung, die die Quelle darstellt, an ein zweites Peltier-Element übertragen wird, und
wobei in einer ersten Betriebsart die lichtemittierende Diode mit elektrischer Energie mit einem ersten Pegel versorgt wird und elektrische Energie, die durch die Peltier-Elemente aus der Abwärme der Leuchtdioden umgewandelt wird, einem elektrischen Verbraucher bereitgestellt wird oder in einer Speichervorrichtung gespeichert bereitgestellt wird, und in einer zweiten Betriebsart elektrische Energie zur Versorgung von, zumindest einem Peltier-Element mit elektrischer Energie wird und das Peltier-Element **durch** diese elektrische Energie abgekühlt wird, wenn die Lichtabstrahlung, die von dem lichtemittierenden Kristall emittiert wird, erhöht wird.

4. Verfahren nach Anspruch 3, wobei die Wärme aus dem lichtemittierenden Kristall mittels elektrischer Drähte, welche die Anode und / oder die Quelle bilden, übertragen wird.

## Revendications

1. Agencement de diode électroluminescente comprenant une diode électroluminescente avec un cristal électroluminescent, connecté électriquement à une anode et une source,
**caractérisé en ce qu'**une de l'anode et de la source est couplée thermiquement à un premier conducteur de chaleur, le conducteur de chaleur étant couplé thermiquement à un premier élément Peltier pour convertir en énergie électrique une énergie thermique transmise à partir de et générée dans le cristal électroluminescent quand le cristal électroluminescent est alimenté en énergie électrique,
dans lequel l'autre de l'anode et de la source est couplée thermiquement à un deuxième conducteur de chaleur, le deuxième conducteur de chaleur étant couplé thermiquement à un deuxième élément Peltier pour convertir en énergie électrique une énergie thermique transmise à partir de et générée dans le cristal électroluminescent quand le cristal électroluminescent est alimenté en énergie électrique,
comprenant en outre une unité de commande adaptée pour piloter la diode électroluminescente dans
- un premier mode, dans lequel une énergie électrique d'un premier niveau est fournie à la diode électroluminescente et une énergie électrique convertie à partir de chaleur dissipée par la diode électroluminescente dans les éléments Peltier est reçue et fournie à un consommateur électrique ou dispositif de stockage, et dans
- un deuxième mode, dans lequel une énergie électrique d'un deuxième niveau est fournie à la diode électroluminescente et une énergie électrique est fournie aux éléments Peltier pour refroidir les éléments Peltier et refroidir ainsi de manière active la diode électroluminescente par l'intermédiaire des éléments Peltier,
- dans lequel le deuxième niveau d'énergie électrique est supérieur au premier niveau.

2. Agencement de diode électroluminescente selon la revendication 1, dans lequel un ou les deux des premier et deuxième éléments Peltier sont couplés électriquement à un dispositif de stockage électrique pour stocker l'énergie électrique générée dans le ou les éléments Peltier.

3. Procédé de commande d'une diode électroluminescente, comprenant l'étape de fourniture d'énergie électrique une anode et une source couplées électriquement à un cristal électroluminescent incorporé dans la diode électroluminescente, **caractérisé par** les étapes de transfert de chaleur du cristal électroluminescent à un élément Peltier et de conversion de ladite chaleur dans ledit élément Peltier en énergie électrique, dans lequel ladite énergie électrique générée dans l'élément Peltier est transférée de préférence à un stockage d'énergie électrique ou un consommateur électrique,
dans lequel la chaleur est transférée à partir du cristal électroluminescent par l'intermédiaire d'un fil électrique constituant le couplage d'anode à un premier élément Peltier et par l'intermédiaire d'un fil électrique constituant le couplage de source à un deuxième élément Peltier et
dans lequel
dans un premier mode, une énergie électrique d'un premier niveau est fournie au cristal électroluminescent et une énergie électrique convertie partir de chaleur dissipée par le cristal électroluminescent dans le ou les éléments Peltier est fournie à un consommateur électrique ou dispositif de stockage, et dans un deuxième mode, une énergie électrique est fournie à au moins un élément Peltier et l'élément Peltier est refroidi par cette énergie électrique si le rayonnement lumineux émis par le cristal électroluminescent est augmenté.

4. Procédé selon la revendication 3, dans lequel la chaleur est transférée du cristal électroluminescent à l'élément Peltier par l'intermédiaire de fils électriques constituant l'anode et/ou la source.
